# EUROPÄISCHE PATENTSCHRIFT

(11) **EP 1 720 022 B1**
(45) Veröffentlichungstag und Bekanntmachung des Hinweises auf die Patenterteilung: **16.06.2010**
(21) Anmeldenummer: 05009485.3
(22) Anmeldetag: 29.04.2005
(51) Int. Cl.: G01R 13/30, G01R 13/32, H04L 12/26, H04J 3/06, H04B 7/26, H04B 1/707

(54) **Zeitlich synchronisiertes Messsystem und Verfahren zum zeitlichen Synchronisieren von mindestens einer Master- und einer Slave-Vorrichtung**
Time-synchronized measuring system and method of synchronizing at least one master/slave device
Dispositif de mesure synchronisé dans le temps et méthode pour la synchronisation dans le temps d'au moins un dispositif maître/esclave

(43) Veröffentlichungstag der Anmeldung: 08.11.2006
(73) Patentinhaber: Tektronix International Sales GmbH, 8212 Neuhausen (CH)
(72) Erfinder: Förster, Sven, 16567 Mühlenbeck (DE); Schmack, Steffen, 12683 Berlin (DE); Schuricht, Michael, 13467 Berlin (DE); Vollmer, Hans-Ulrich, 12109 Berlin (DE)
(74) Vertreter: Schurack, Eduard F.

(56) Entgegenhaltungen:
- EP-A- 0 738 055
- US-A- 4 494 211
- US-A1- 2002 001 299
- US-A1- 2002 178 292
- US-A1- 2004 001 483
- US-A1- 2004 062 278
- US-B1- 6 188 286
- US-B1- 6 675 339

## Beschreibung

Die vorliegende Erfindung betrifft ein zeitlich synchronisiertes Messsystem, umfassend mindestens eine Master-Vorrichtung und mindestens eine Slave-Vorrichtung, wobei die Master- und die Slave-Vorrichtung jeweils eine Zeitmessvorrichtung umfassen und ausgelegt sind, den jeweiligen Zeitpunkt des Sendens und/oder des Empfangs einer Messinformation der jeweiligen Messinformation zuzuordnen, wobei die Master-Vorrichtung eine Referenztakterzeugungsvorrichtung umfasst und ausgelegt ist, ein von der Referenztakterzeugungsvorrichtung erzeugtes Referenztaktsignal an die Slave-Vorrichtung zu übermitteln. Sie betrifft überdies ein Verfahren zum zeitlichen Synchronisieren von mindestens einer Master- und einer Slave-Vorrichtung, wobei die Master-und die Slave-Vorrichtung jeweils eine Zeitmessvorrichtung umfassen und der jeweilige Zeitpunkt den Sendens und/oder des Empfangs einer Messinformation der jeweiligen Messinformation zugeordnet wird, wobei die Mastervorrichtung eine Referenztakterzeugungsvorrichtung umfasst und eine von der Referenztakterzeugungsvorrichtung erzeugtes Referenztaktsignal an die Slave-Vorrichtung übermittelt wird.

Eine derartige Vorrichtung und ein derartiges Verfahren sind aus dem Stand der Technik bekannt. Die der vorliegenden Erfindung zugrunde liegende Problematik wird der einfacheren Verständlichkeit wegen im Nachfolgenden am Beispiel der Protokollmesstechnik dargestellt. Wie für den Fachmann offensichtlich, sind andere Einsatzgebiete im Bereich der Messtechnik, beispielsweise zur Verwendung bei Oszilloskopen, Network-Analyzern, Logic-Analyzern und dergleichen, denkbar.

Im Bereich der Protokollmesstechnik werden Protokolltester und Monitoringgeräte eingesetzt, die im Falle eines Protokolltesters Protokollnachrichten senden und empfangen, im Falle eines Monitoring-Geräts Protokollnachrichten nur empfangen. Um die gewünschten Rückschlüsse, beispielsweise auf Probleme bei der Übertragung, ziehen zu können, werden die Protokollnachrichten, gleichgültig ob empfangene oder gesendete Protokollnachrichten, mit einem Zeitstempel versehen und gespeichert. Für unterschiedliche Protokollnachrichten können hierbei unterschiedliche Schaltungseinheiten zuständig sein, wobei hinsichtlich des Zeitstempels keine Probleme auftreten, wenn diese unterschiedlichen Schaltungseinheiten beispielsweise unterschiedliche Messkarten ein und desselben Protokolltesters bzw. ein und desselben Monitoringgeräts sind. Denn dann kann in diesem Protokolltester bzw. in diesem Monitoringgerät eine Zeitbasis, beispielsweise eine Testzeit oder eine Absolutzeit, festgesetzt werden und diese Zeitbasis bildet die gemeinsame Zeitbasis für alle Messkarten dieser Vorrichtung. Mit anderen Worten können die Zeitstempel, die von den unterschiedlichen Messkarten erzeugt werden, zueinander in Relation gesetzt werden, da sie sich alle auf dieselbe Zeitbasis beziehen. Problematisch wird das Ganze, wenn die entsprechenden Messkarten in unterschiedlichen Geräten, d. h. unterschiedlichen Protokolltestern bzw. Monitoringgeräten, implementiert sind. Es besteht daher grundsätzlich der Wunsch, die unterschiedlichen Protokolltester bzw. Monitoringgeräte hinsichtlich der gemeinsamen Zeitbasis zu synchronisieren.

Im Stand der Technik ist es in diesem Zusammenhang bekannt, dass ein Protokolltester bzw. Monitoringgerät als Master-Vorrichtung fungiert, ein anderer Protokolltester bzw. ein anderes Monitoringgerät als Slave-Vorrichtung. Die Master-Vorrichtung verfügt über eine Referenztakterzeugungsvorrichtung und stellt an die Slave-Vorrichtung ein Referenztaktsignal über eine entsprechende separate Leitung bereit. Sowohl die Master- als auch die Slave-Vorrichtung verfügen über eine Zeitmessvorrichtung, wobei die Zeitmessvorrichtungen auf das Referenztaktsignal synchronisiert werden. Damit laufen zwar die beiden Zeitmessvorrichtungen synchron, es verbleibt jedoch zunächst das Problem, die beiden Zeitmessvorrichtungen auf eine gemeinsame Zeitbasis, d. h. auf eine gemeinsame Testzeit oder Absolutzeit, einzustellen. Gewöhnlich sind die Master- und die Slave-Vorrichtung beispielsweise in einem Labor über ein Kommunikationsnetzwerk, beispielsweise Ethernet, miteinander verbunden. Mit diesem Ethernet kann auch ein Zeitserver verbunden sein, wobei die Master- und die Slave-Vorrichtung Informationen zur gemeinsamen Zeitbasis über dieses Ethernet beim Zeitserver abfragen. Problematisch daran ist, dass Informationen zur gemeinsamen Zeitbasis auf ein bestimmtes, vorher vereinbartes Signal, das vom Zeitserver ausgeht, bezogen sind. Wann dieses vereinbarte Signal bei der Master- bzw. der Slave-Vorrichtung eintrifft, hängt zum einen von der Entfernung der jeweiligen Vorrichtung zum Zeitserver ab, zum anderen von der Auslastung, d. h. dem Verkehrsaufkommen, auf dem Netzwerk. Wird beispielsweise als Referenztaktsignal ein 10 MHz-Rechtecksignal verwendet, so könnte damit eine Auflösung von 100 ns erreicht werden. Aufgrund der oben erwähnten Effekte können sich jedoch bereits Abweichungen im Bereich von ms der beiden Zeitmessvorrichtungen voneinander ergeben.

Eine andere bekannte Vorgehensweise sieht vor, sowohl die Master- als auch die Slave-Vorrichtung mit einem GPS (Global Positioning System)-Empfänger auszustatten und für die Einstellung einer gemeinsamen Zeitbasis auf die mit dem GPS-Signal ausgestrahlte Zeitinformation (z. B. UTC) zu synchronisieren. Diese Vorgehensweise ist jedoch einerseits teuer, zum anderen berücksichtigt sie nicht, dass in vielen Laborumgebungen kein Zugang für eine GPS-Antenne vorhanden ist.

Im Zusammenhang mit zeitlicher Synchronisation wird ferner auf folgenden Stand der Technik verwiesen:

Die US 6,188,286 B1 offenbart ein Verfahren und ein System zum Synchronisieren einer Vielzahl von Untersystemen mittels eines spannungsgesteuerten Oszillators. Eine Vielzahl von Untersystemen ist auf einer Leiterplatte angeordnet, wobei ein Untersystem als Master und die übrigen als Slaves fungieren. Das Ausgangssignal eines spannungsgesteuerten Oszillators wird sowohl dem Master als auch den Slaves zugeführt, wobei es frequenz- und phasenabgeglichen bei 0° ist. Ferner wird ein periodisches Referenzsignal, das durch eine externe Systemschnittstelle bereitgestellt wird, und dessen Periode ein Vielfaches der Periode des Signals des spannungsgesteuerten Oszillators beträgt, jedem Untersystem phasenabgeglichen zugeführt. Zur Synchronisation der Untersysteme untereinander erzeugt der Master ein Synchronisationssignal, das den übrigen Untersystemen übermittelt wird. Dazu ist der Master elektrisch mit dem spannungsgesteuerten Oszillator gekoppelt und führt einen Phasenabgleich des Ausgangssignals des spannungsgesteuerten Oszillators mit dem Referenzsignal durch, wodurch ein internes Referenzsignal des Masters ebenfalls mit dem Referenzsignal abgeglichen wird. Das vom Master erzeugte Synchronisationssignal stellt eine verzögerte Halbperiode des internen Referenzsignals des Masters dar. Ein als Slave fungierendes Untersystem tastet das Synchronisationssignal bei jeder ansteigenden Flanke des Ausgangssignals des spannungsgesteuerten Oszillators ab. Da die gesamte Verzögerung von der abfallenden Flanke des internen Referenzsignals des Masters bis zum Empfang des Synchronisationssignals durch den Slave weniger als eine Periode des Ausgangssignals des spannungsgesteuerten Oszillators beträgt, kann der Slave den Beginn eines internen Referenzsignals des Slaves, das mit dem internen Referenzsignal des Masters synchronisiert ist, auf der Basis des Faktors bestimmen, mit dem die Frequenz des internen Referenzsignals des Masters zu multiplizieren ist, um die Frequenz des Ausgangssignals des spannungsgesteuerten Oszillators zu erhalten.

Aus der US 2004/0001483 A1 ist ein System und ein Verfahren zur Verteilung und Rekonstruktion von Ad-hoc-Timing-Signalen bekannt. Ein Kommunikationssystem enthält eine erste und eine zweite Schaltung, die durch einen Bus miteinander verbunden sind. Die erste Schaltung enthält einen Busmaster, der Bustaktsignale erzeugt und das auf dem Bus verwendete Protokoll definiert. Insbesondere wird ein Zeitmultiplexverfahren verwendet, bei dem die Periode des Bustaktsignals in Frames unterteilt ist, die wiederum in Zeitschlitze unterteilt sind. Die erste Schaltung enthält ferner eine Datenschaltung und eine Zeitsteuerungsschaltung und einen internen Bus, der diese Schaltungen untereinander und mit dem Busmaster verbindet. Die zweite Schaltung enthält einen Busslave, der mit dem Bus verbunden ist und dem durch den Busmaster definierten Protokoll und Timing folgt. Die zweite Schaltung enthält auch eine Datenschaltung und eine Zeitsteuerungsschaltung und einen internen Bus, der diese Schaltungen untereinander und mit dem Busslave verbindet. Dabei haben die internen Busse jeweils ein definiertes zeitliches Verhältnis zu dem Bus, der die erste und die zweite Schaltung verbindet. Empfängt die Zeitsteuerungsschaltung der ersten Schaltung ein AMI-Taktsignal, bildet sie daraus ein extrahiertes Taktsignal und stellt fest, in welchem Frame und Zeitschlitz eine Flanke des extrahierten Taktsignals liegt. Diese Information wird an die Zeitsteuerungsschaltung der zweiten Schaltung übermittelt. Diese rekonstruiert unter Berücksichtigung der bei der Initialisierung ermittelten zeitlichen Verzögerung und der bekannten Periode des Taktsignals ein Taktsignal in der zweiten Schaltung, dessen Flanken den Flanken des Taktsignals in der ersten Schaltung entsprechen.

Die US 4,494,211 offenbart ein System zur Entfernungsmessung und Synchronisation zwischen Satellitenpaaren, wobei Master und Slave austauschbar sind. Jeder Satellit enthält einen Taktgeber, einen Sender, einen Empfänger, eine Vorrichtung zum Messen eines Zeitunterschieds und eine Rechenvorrichtung. Jeder Satellit sendet mit seinem Taktgeber synchronisierte Timingsignale, empfängt die Timingsignale des anderen Satelliten und misst die Zeitdifferenz zwischen dem Senden der eigenen und dem Empfang der vom anderen Satelliten stammenden Timingsignale. Die gemessene Zeitdifferenz wird dann dem anderen Satelliten übermittelt, um daraus die Asynchronie zwischen den Taktgebern und die Entfernung zwischen den Satelliten zu berechnen. Zur Synchronisation werden im Slave beim Herunterteilen der Frequenz eines vom Taktgeber erzeugten Basistaktes Takte eingefügt bzw. weggelassen, bis die Asynchronie der erzeugten Taktsignale auf ein Maß innerhalb vorbestimmter Grenzen reduziert wird.

Aus der US 2002/0178292 A1 sind ein Verfahren und eine Vorrichtung zum Synchronisieren eines Netzwerks von Kommunikationsstationen, die an ein gemeinsam genutztes physisches Kommunikationsmedium, beispielsweise die Stromleitung, angeschlossen sind, wobei diese sowohl zur Übermittlung von Daten als auch zur Übermittlung von Synchronisationssignalen verwendet wird, bekannt. Jede Station zieht von den empfangenen Synchronisationssignalen nur diejenigen mit einer früheren Phase als die Phase ihres internen Taktgebers in Betracht. Von diesen Synchronisationssignalen wird dann nur das früheste zur Synchronisation des internen Taktgebers verwendet. Sobald eine Station Synchronisation herbeigeführt hat, beginnt sie selbst Synchronisationssignale auszusenden. Auf diese Weise fungiert die Station mit dem schnellsten internen Taktgeber als Ad-hoc-Synchronisationsmaster für die übrigen Stationen.

Die US 2004/0062278 A1 offenbart ein System und ein Verfahren zum Synchronisieren des Takts eines lokalen Telekommunikationsnetzwerks, das über ein asynchrones Transportnetzwerk, wie ein Ethemet-Netzwerk, mit einem entfernten Taktgeber verbunden ist. Dazu wird ein erstes rekonstruiertes Taktfrequenzsignal aus den Anrufabständen der Datenpakete berechnet. Ein zweites rekonstruiertes Taktfrequenzsignal wird aus Zeitstempeln berechnet, mit denen ausgehende und eingehende Datenpakete versehen werden. Eine Kombination dieser beiden rekonstruierten Taktfrequenzsignale wird dann dazu verwendet, das gegenwärtige rekonstruierte Taktfrequenzsignal zu korrigieren.

Die EP 0 738 055 A2 schließlich offenbart ein Phasensynchronisationssystem, das eine beim Senden von einem Master zu einem Slave auftretende Phasenverzögerung eines Referenzsignals für ein bidirektionales Wellenlängenmultiplexkommunikationssystem bestimmt. Dazu wird einerseits eine Phasenverzögerung gemessen, die sich durch Senden eines Signals einer ersten Wellenlänge von einem Master über einen Lichtwellenleiter zu einem Slave und von dem Slave mit einer zweiten Wellenlänge über den Lichtwellenleiter zu dem Master zurück ergibt. Andererseits wird die Phasendifferenz gemessen, die sich beim gleichzeitigen Senden eines Signals mit der ersten und der zweiten Wellenlänge vom Master zum Slave ergibt. Aus diesen beiden Größen kann die Verzögerungszeit zwischen dem Master und dem Slave direkt berechnet werden.

Die Aufgabe der vorliegenden Erfindung besteht darin, das eingangs genannte Messsystem bzw. das eingangs genannte Verfahren derart weiterzubilden, dass eine kostengünstige und zuverlässige Synchronisation einer Master- und einer Slave-Vorrichtung auf eine gemeinsame Zeitbasis ermöglicht wird.

Diese Aufgabe wird gelöst durch ein Messsystem mit den Merkmalen von Patentanspruch 1 und ein Verfahren mit den Merkmalen von Patentanspruch 13.

Die vorliegende Erfindung basiert auf der Erkenntnis, dass die oben erwähnte Aufgabe gelöst werden kann, wenn die Übertragung des Referenztaktsignals von der Masterzur Slave-Vorrichtung genutzt wird, um zusätzlich Informationen zu einer gemeinsamen Zeitbasis zu übertragen. Dazu wird das Referenztaktsignal moduliert, wobei die Modulation eine Information zu dieser gemeinsamen Zeitbasis umfasst. Diese Übertragung ist unabhängig von einem Verkehrsaufkommen auf dem Netz, über das die Master- und die Slave-Vorrichtung überdies in Verbindung stehen. Die Laufzeit zwischen Master- und Slave-Vorrichtung ist daher im Wesentlichen eine Konstante und könnte bei größeren Entfernungen zwischen Master- und Slave-Vorrichtung berücksichtigt werden, siehe herzu unsere Ausführungen weiter unten. Die Leitung, die zur Übertragung des Referenztaktsignals von der Master- zur Slave-Vorrichtung ohnehin vorhanden ist, wird daher in optimaler Weise für eine zweite Nutzung verwendet.

Als Modulationsverfahren kommen insbesondere Amplitudenmodulation, Pulsweitenmodulation oder Kodierverfahren, wie sie für die digitale Datenübertragung Anwendung finden, beispielsweise NRZ, Manchestercode und dergleichen, zur Anwendung. Es kann auch vorgesehen werden, durch Multitasking abwechselnd ein Referenztaktsignal und Informationen zur gemeinsamen Zeitbasis zu übertragen, wobei dies vorliegend ebenfalls unter den Begriff "Modulation" fallen soll.

Am Beispiel einer einfachen Pulsweitenmodulation wird beispielsweise die meiste Zeit ein bestimmtes Muster übertragen, das zum Beispiel einer logischen "0" entspricht. Dieses Muster wird periodisch, beispielsweise jede Sekunde, durch einen Informationsblock betreffend die gemeinsame Zeitbasis unterbrochen. Dieser Informationsblock besteht bevorzugt aus einem Startmuster, welches darauf hinweist, dass nunmehr der eigentliche Informationsblock übertragen wird, und diesem eigentlichen Informationsblock. Für die Einstellung der Zeitmessvorrichtung der Slave-Vorrichtung auf die gemeinsame Zeitbasis muss die Beziehung zwischen der Information betreffend die gemeinsame Zeitbasis und dem modulierten Signal bekannt sein. Die gemeinsame Zeitbasis könnte sich beispielsweise auf den Start des eigentlichen Informationsblocks beziehen. Eine andere Option wäre, die gemeinsame Zeitbasis auf eine bekannte Bitposition innerhalb des eigentlichen Informationsblocks (beispielsweise das 64. Bit oder das letzte Bit) zu beziehen. Eine andere Option wäre beispielsweise, die gemeinsame Zeitbasis auf den Start oder eine bekannte Bitposition innerhalb des nächsten Informationsblocks zu beziehen.

Es kann vorgesehen werden, durch Modulation des Referenztaktsignals weitere, insbesondere zeitkritische, Informationen von der Master- zur Slave-Vorrichtung zu übertragen. Überdies kann eine Prüfsumme dem Informationsblock hinzugefügt werden.

Wie bereits erwähnt, ist bei einer bevorzugten Ausführungsform des erfindungsgemäßen zeitlich synchronisierten Messsystems die Master-Vorrichtung eine Master-Kommunikationsvorrichtung, die Slave-Vorrichtung eine Slave-Kommunikationsvorrichtung und die Messinformation eine Protokollnachricht in einem Telekommunikationsnetzwerk.

Die gemeinsame Zeitbasis kann die Absolutzeit sein, beispielsweise in Jahr, Monat, Tag, Stunde, Minuten, Sekunden usw., wobei es sich um UTC, MEZ oder beispielsweise das julianische Datum handeln kann. Die gemeinsame Zeitbasis kann jedoch auch eine Systemzeit, insbesondere eine Testzeit, sein, die zu Beginn eines Tests zu laufen beginnt. Bei einer einfachen Ausführungsform können hierfür zwei 32-Bit-Werte verwendet werden, von denen einer die Sekunden, der andere die Nachkommastellen der Sekunden zählt.

Bevorzugt wird das Referenztaktsignal gleichstromfrei übertragen und die Modulation erfolgt derart, dass auch das modulierte Referenztaktsignal gleichstromfrei übertragen werden kann, selbst wenn das Referenztaktsignal in der Master-Vorrichtung und/oder in der Slave-Vorrichtung einen Gleichanteil aufweist. Dies stellt die Möglichkeit bereit, zur Kopplung Induktivitäten und/oder Kondensatoren zu verwenden.

Die Modulation kann darin bestehen, dass ein zwischen der Master- und der Slave-Vorrichtung vereinbartes Signal den Start einer Systemzeit definiert. Wird beispielsweise fortlaufend ein bestimmtes Bitmuster übertragen, beispielsweise ein Bitmuster, das eine logische "0" definiert, so kann die erstmalige Übertragung eines anderen Bitmusters, beispielsweise eines Bitmuster, das eine logische "1" definiert, den Beginn der Systemzeit festlegen. Bei dieser Vorgehensweise sind die Anforderungen an die Modulation minimal.

Die Modulation kann jedoch auch darin bestehen, dass die aktuelle Zeit bezogen auf die gemeinsame Zeitbasis, insbesondere die Absolutzeit, mit Bezug auf ein zwischen der Master- und der Slave-Vorrichtung vereinbartes Signal in kodierter Form übertragen wird, wie beispielsweise in dem weiter oben bereits erwähnten eigentlichen Informationsblock.

Insbesondere bei einer Entfernung zwischen einer Master- und einer Slave-Vorrichtung, die so groß ist, dass die Laufzeit des modulierten Referenztaktsignals von der Master- an die Slave-Vorrichtung im Hinblick auf die Genauigkeit berücksichtigt werden sollte, kann eine Laufzeitermittlungsvorrichtung vorgesehen werden, die die Laufzeit des Referenztaktsignals zwischen der Master- und der Slave-Vorrichtung ermittelt und diese Laufzeit bei der Modulation des Referenztaktsignals berücksichtigt. Bevorzugt umfasst die Laufzeitermittlungsvorrichtung neben der Leitung, auf der das Referenztaktsignal übertragen wird, eine weitere Leitung, auf der ein Signal von der Slave- an die Master-Vorrichtung übertragen werden kann. Durch Messung der Laufzeit über Hin- und Rückleitung und Halbierung dieses Messwerts lässt sich eine gute Annäherung an die Laufzeit ermitteln.

Sollen zwei Messsysteme mit jeweils einer Mastervorrichtung aufeinander synchronisiert werden, die so weit auseinander liegen, dass es schwierig ist, eine Leitung zur Übertragung eines modulierten Referenztaktsignals vorzusehen, so kann die Einrichtung einer gemeinsamen Zeitbasis dennoch erfolgen: Dabei umfasst jede Master-Vorrichtung jeweils eine Referenztakterzeugungsvorrichtung, jeweils eine Zeitmessvorrichtung, die zunächst nicht miteinander synchronisiert sind, und jeweils einen GPS-Empfänger, wobei jeder GPS-Empfänger ausgelegt ist, ein Pulssignal, insbesondere mit einem Puls pro Sekunde, an die jeweilige Referenztakterzeugungsvorrichtung zum Zwecke der Synchronisation bereitzustellen, und ein Absolutzeitsignal zu empfangen und zur Einstellung der jeweiligen Zeitmessvorrichtung an die jeweilige Zeitmessvorrichtung bereitzustellen. Auf diese Weise können andere Master-Vorrichtungen und die damit jeweils verbundenen Slave-Vorrichtungen miteinander synchronisiert werden.

Bei einer bevorzugten Ausführungsform beträgt das Referenztaktsignal 10 MHz. Im Besonderen kann es sich hierbei um ein Rechtecksignal handeln.

Weiterhin ist bei einer bevorzugten Ausführungsform vorgesehen, dass im modulierten Referenztaktsignal eine logische "0" definiert ist durch eine Periode des Referenztaktsignals mit einem 75/25 Tastverhältnis und eine Periode des Referenztaktsignals mit einem 25/75 Tastverhältnis (oder durch eine zweimalige Abfolge dieser Signale), und eine logische "1" definiert ist durch zwei Perioden des Referenztaktsignals mit einem 75/25 Tastverhältnis und zwei Perioden des Referenztaktsignals mit einem 25/75 Tastverhältnis und weiterhin durch zwei Perioden des Referenztaktsignals mit einem 25/75 Tastverhältnis und zwei Perioden des Referenztaktsignals mit einem 75/25 Tastverhältnis. Die Vereinbarung zweier unterschiedlicher Muster für eine "1" stellt die Möglichkeit bereit, dass der Informationsblock zu jeder Taktperiode des Referenztaktsignals gestartet werden kann. Dies resultiert bei gegebenem Referenztaktsignal in einer doppelt so hohen Genauigkeit, da am Beispiel eines 10 MHz Referenztaktsignals kein einer 0 oder einer 1 entsprechender Block von zwei bzw. vier Taktperioden abgeschlossen werden muss, sondern bereits nach einer Taktperiode einer "0" auf eine "1" gewechselt werden kann. Je nach dem, welches Bitmuster der "0" zum Zeitpunkt des gewünschten Übergangs auf eine "1" gerade vorliegt, d. h. ein Taktzyklus mit einem 75/25 Tastverhältnis oder ein Taktzyklus mit einem 25/75 Tastverhältnis, wird auf ein anderes "1 "-Signal gesprungen. Als Konsequenz ergibt sich eine symmetrische Generator-Zustandsmaschine.

Bevorzugt sind in einem zeitlich synchronisierten Messsystem mehrere Slave-Vorrichtungen vorhanden, wobei jede Slave-Vorrichtung einen Ausgang aufweist, an dem sie das modulierte Referenztaktsignal an eine weitere Slave-Vorrichtung bereitstellen kann. Dadurch lässt sich eine so genannte Daisy-Chain aufbauen.

Die oben im Zusammenhang mit dem erfindungsgemäßen, zeitlich synchronisierten Messsystem vorgestellten bevorzugten Ausführungsformen gelten entsprechend für das erfindungsgemäße Verfahren.

Weitere vorteilhafte Ausführungsformen sind den Unteransprüchen zu entnehmen.

Im Nachfolgenden wird nunmehr ein Ausführungsbeispiel der Erfindung unter Bezugnahme auf die beigefügten Zeichnungen näher beschrieben. Es zeigen:
- Fig. 1: in schematischer Darstellung eine Ausführungsform eines erfindungsgemäßen Messsystems;
- Fig. 2: ein Ausführungsbeispiel für die Modulation des Referenztaktsignals;
- Fig. 3: die Generator-Zustandsmaschine für das gemäß Fig. 2 modulierte Referenztaktsignal; und
- Fig. 4: eine Blockschaltbilddarstellung eines Ausführungsbeispiels einer erfindungsgemäßen Vorrichtung, die als Master- oder als Slave-Vorrichtung eingesetzt werden kann.

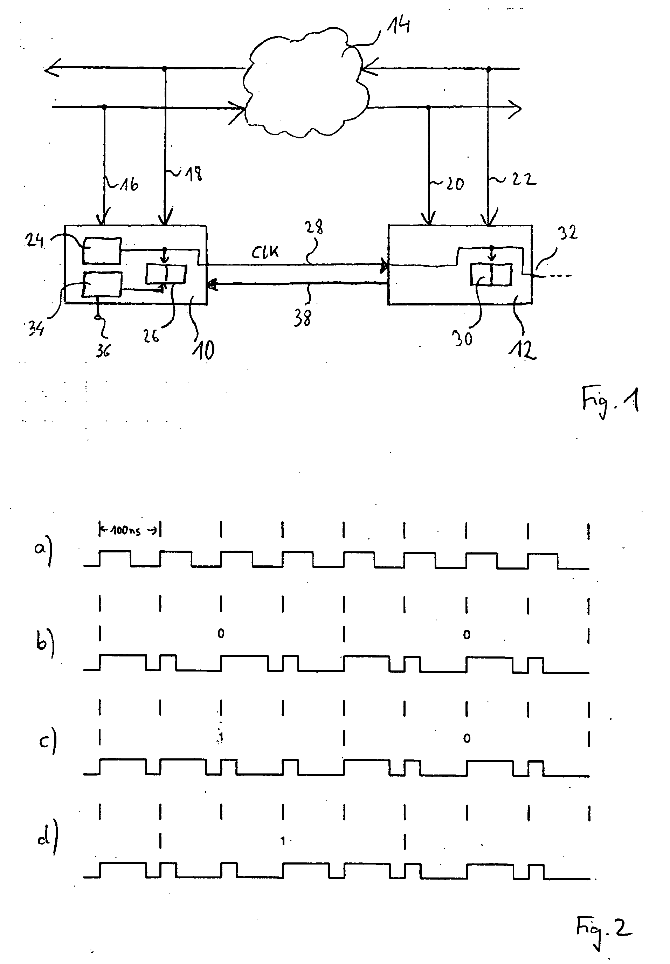

Fig. 1 zeigt ein Ausführungsbeispiel eines erfindungsgemäßen Messsystems, bei dem eine Master-Vorrichtung 10 und eine Slave-Vorrichtung 12 mit einem Kommunikationsnetzwerk 14 verbunden sind, wobei die Master-Vorrichtung 10 über eine Leitung 16 und eine Leitung 18 und die Slave-Vorrichtung über Leitungen 20 und 22 Informationen, insbesondere Messinformationen, aus dem Kommunikationsnetzwerk 14 beziehen. Die Master-Vorrichtung 10 weist eine Referenztakterzeugungsvorrichtung 24 auf, die ein Referenztaktsignal Clk an eine in der Master-Vorrichtung 10 angeordnete Zeitmessvorrichtung 26, beispielsweise eine Uhr, bereitstellt. Dieses Referenztaktsignal Clk wird überdies von der Master-Vorrichtung 10 über eine Leitung 28 auch an die Slave-Vorrichtung 12 bereitgestellt. In der Slave-Vorrichtung 12 wird das Referenztaktsignal einer Zeitmessvorrichtung 30 bereitgestellt und ebenso an einen Ausgang 32 für weitere daran anzuschließende Slave-Vorrichtungen (nicht dargestellt). Die Master-Vorrichtung 10 umfasst eine Vorrichtung zum Starten einer Testzeit oder zum Einstellen einer Absolutzeit. Die Testzeit kann beispielsweise automatisch zu laufen beginnen, wenn über die Master-Vorrichtung 10 ein Testlauf gestartet wird. Alternativ kann die Master-Vorrichtung 10 beispielsweise einen GPS-Empfänger 34 umfassen, der über einen Anschluss 36 mit einer GPS-Antenne verbunden ist. Über den GPS-Empfänger 34 wird ein 1pps (puls per second)-Signal sowie ein Absolutzeitsignal empfangen. In der Master-Vorrichtung 10 wird das 1 pps-Signal verwendet, um die Referenztakterzeugungsvorrichtung 24 damit zu synchronisieren. Das Absolutzeitsignal wird verwendet, um auf der Zeitmessvorrichtung 26 die Absolutzeit einzustellen. Weiter alternativ kann die Master-Vorrichtung 10 über eine der Leitungen 16, 18 ein Signal zu einer gemeinsamen Zeitbasis, beispielsweise von einem Zeitserver, empfangen und zum Einstellen der Zeitmessvorrichtung 26 verwenden.

Über die Leitung 28 sind die Zeitmessvorrichtungen 26 der Master-Vorrichtung 10 sowie die Zeitmessvorrichtung 30 der Slave-Vorrichtung 12 miteinander synchronisiert.

Erfindungsgemäß wird nämlich das über die Leitung 28 übertragene Referenztaktsignal moduliert, wobei die Modulation eine Information zu der gemeinsamen Zeitbasis der Master- und der Slave-Vorrichtung umfasst, die dann zur Einstellung der Zeitmessvorichtung 30 der Slave-Vorrichtung 12 verwendet wird.

Zur Ermittlung der Laufzeit eines Signals zwischen der Master-Vorrichtung 10 und der Slave-Vorrichtung 12 wird ein Signal von der Master-Vorrichtung 10 über die Leitung 28 an die Slave-Vorrichtung 12 gesendet und von der Slave-Vorrichtung 12 über eine Leitung 38 zurück an die Master-Vorrichtung 10 gesendet. Aus der Differenz zwischen dem Senden des Signals von der Master-Vorrichtung 10 und dem Empfang desselben Signals wieder von der Master-Vorrichtung 10 lässt sich unter Berücksichtigung bekannter Verarbeitungszeiten die Laufzeit ermitteln und bei der Modulation des Referenztaktsignals, beispielsweise zur Kompensation, berücksichtigen.

Fig. 2 zeigt den zeitlichen Verlauf des Referenztaktsignals, wobei vorliegend eine Periode 100 ns dauert, was umgekehrt einer Frequenz von 10 MHz entspricht, siehe Kurvenzug a). Kurvenzug b) zeigt ein moduliertes Referenztaktsignal, wobei die Modulation darin besteht, dass fortlaufend eine zuvor vereinbarte "0" gesendet wird. Eine logische "0" ist vorliegend definiert durch vier Periodendauern, wobei die dritte und die vierte Periodendauer identisch sind zu der ersten und der zweiten Periodendauer. Die erste Periodendauer zeigt ein Tastverhältnis von 75/25, die zweite Periodendauer ein Tastverhältnis von 25/75. Kurvenzug c) zeigt eine erste Variante einer logischen "1", die definiert ist durch ebenfalls vier Periodendauern, wobei die erste und die zweite Periodendauer ein Tastverhältnis von 75/25 und die dritte und vierte Periodendauer ein Tastverhältnis von 25/75 zeigen. Kurvenzug d) zeigt eine zweite Definition einer logischen "1", wonach die logische "1 "wiederum vier Periodendauern umfasst, wobei die erste und die zweite Periodendauer ein Tastverhältnis von 25/75 und die dritte und die vierte Periodendauer ein Tastverhältnis von 75/25 zeigen.

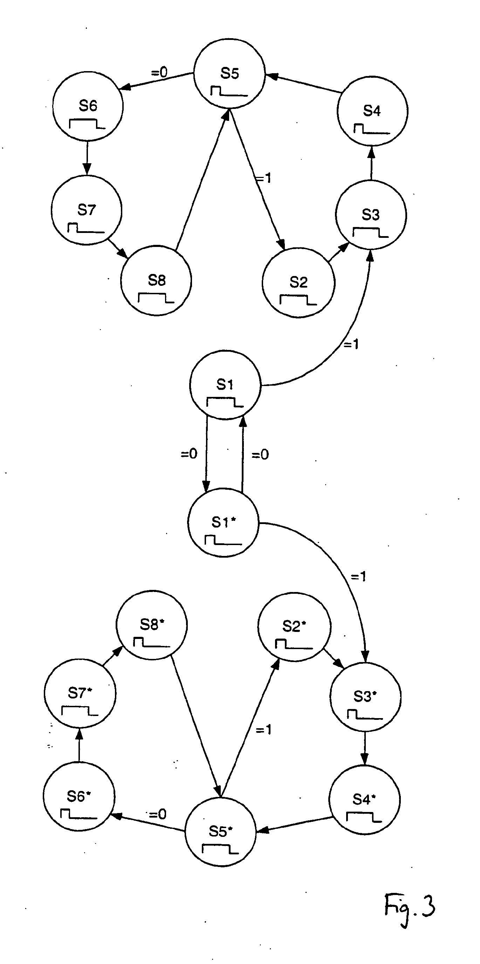

Gemäß der in Fig. 3 dargestellten zugehörigen Generatorzustandsmaschine kann demnach von einer 0 auf eine 1 umgeschaltet werden mit einer Auflösung von einer Periodendauer: Wenn in Kurvenzug b) das Signal zum Umschalten auf eine logische "1" innerhalb der ersten Periodendauer kommt, wird auf die in Kurvenzug c) dargestellte Variante der logischen "1" umgeschaltet, d. h. nach der ersten Periodendauer der "0" weist eine erneute Periodendauer mit einem Tastverhältnis von 75/25 auf einen Übergang auf eine logische "1" hin. Wird das Signal zur Umschaltung auf eine logische "1" innerhalb der zweiten Periode der logischen "0", siehe Kurvenzug b), ausgelöst, wird auf die logische "1" gemäß Kurvenzug d) umgeschaltet, d. h. die "1" startet mit einem Tastverhältnis von 25/75.

Durch das Vorsehen zweier unterschiedlicher Ausprägungen einer logischen "1" kann daher eine Auflösung von 100 ns bei einem 10 MHz Signal erzielt werden. Würde nur eine "1" bereitgestellt werden, könnte ein Umschaltvorgang immer nur nach der zweiten oder der vierten Periodendauer der logischen "0" gemäß Kurvenzug b) erfolgen, d. h. die Auflösung würde nur 200 ns betragen.

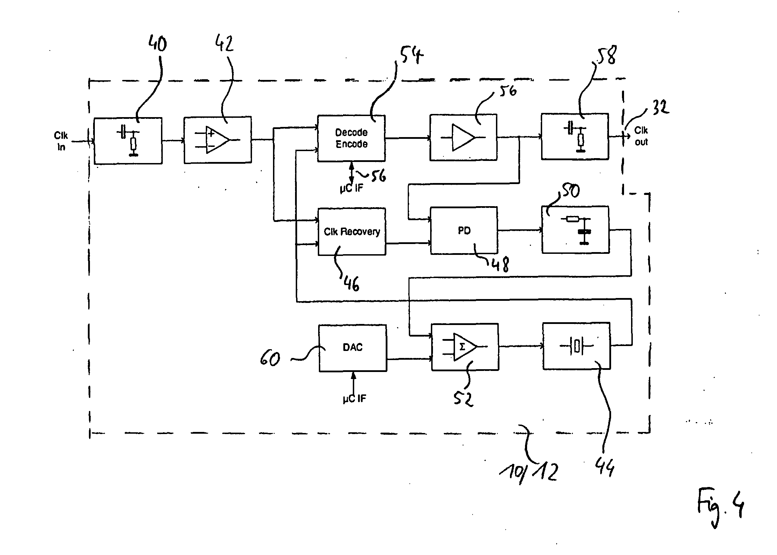

Fig. 4 zeigt in detaillierterer Ansicht eine Ausführungsform einer Vorrichtung, die gleichzeitig als Master- 10 oder als Slave-Vorrichtung 12 eingesetzt werden kann. Hierbei ist vorgesehen, dass Master-Vorrichtungen und Slave-Vorrichtungen identisch aufgebaut sind, d. h. jede Slave-Vorrichtung kann, sofern dies gewünscht oder erforderlich ist, Funktionen einer Master-Vorrichtung übernehmen. Erhält eine derartige Vorrichtung 10/12 ein Referenztaktsignal Clk zugeführt, synchronisiert es seinen internen Oszillator 44 auf das zugeführte Referenztaktsignal und stellt die Zeitmessvorrichtung auf die mit dem Referenztaktsignal übertragene Information zur gemeinsamen Zeitbasis ein. Wird einer derartigen Vorrichtung 10/12 kein Referenztaktsignal zugeführt, dient der Takt des internen Oszillators 44 zur Synchronisation der am Ausgang 32 der Vorrichtung 10/12 angeschlossenen weiteren Vorrichtungen 10/12. Die Information zur gemeinsamen Zeitbasis wird über eine Schnittstelle 56 von einem Zeitserver, einem GPS-Empfänger oder im Falle einer Testzeit von dem Testgerät, in dem diese Vorrichtung installiert ist, bezogen.

Im einzelnen: Die Vorrichtung 10/12 erhält an ihrem Eingang das modulierte Referenztaktsignal, das zunächst eine optionale Vorrichtung 40 zur Abtrennung etwaiger Gleichstromanteile durchläuft, die innerhalb der Vorrichtung 10/12 zu dem gleichstromfrei übertragenen, modulierten Referenztaktsignal hinzugefügt worden sein können. In der Vorrichtung 42 wird aus einem gegebenenfalls infolge einer längeren Übertragung verschliffenen Rechtecksignal das Original-Rechtecksignal zurückgewonnen. Die Vorrichtung 10/12 weist einen Oszillator 44 auf, der auf das Referenztaktsignal synchronisiert werden soll. Dieses durchläuft deshalb nach der Vorrichtung 42 einen Block 46 zur Wiederherstellung des 10 MHz-Takts, einen Phasendiskriminator 48 sowie einen Tiefpass 50 und einen Addierer 52, bevor es an den Oszillator 44 gekoppelt wird.

Dient die Vorrichtung 10/12 als Master-Vorrichtung 10, wird im Block 54 die über eine Schnittstelle 56 zugeführte Information zur gemeinsamen Zeitbasis zur Modulation des Referenztaktsignals verwendet ("Encode"). Das modulierte Referenztaktsignal wird in einem Verstärker 56 verstärkt und über eine Einheit 58, die der Gleichspannungsabtrennung dient, am Ausgang 32, siehe hierzu auch Fig. 1, bereitgestellt. Dient die Vorrichtung 10/12 als Slave-Vorrichtung 12, wird in Block 54 aus dem an ihrem Eingang zugeführten modulierten Referenztaktsignal die Information zur gemeinsamen Zeitbasis gewonnen ("Decode") und über die Schnittstelle 56 an die interne, in Fig. 4 nicht dargestellte Zeitmessvorrichtung 30, siehe Fig. 1, bereitgestellt. Ein optionaler Block 60 dient zur Steuerung der Frequenz des Referenztaktsignals im Masterbetrieb der Vorrichtung 10/12.

Eine Vielzahl derartiger Vorrichtungen 10/12 kann in Form einer so genannten Daisy-Chain miteinander verbunden werden. Hierbei fungiert die erste Vorrichtung 10/12 in der Reihe als Master-Vorrichtung 10 und stellt an ihrem Ausgang 32 ein moduliertes Referenztaktsignal bereit. Die nächste Vorrichtung 10/12 in der Kette fungiert als Slave-Vorrichtung und verwendet das modulierte Referenztaktsignal, um seinen internen Oszillator zu synchronisieren und seine interne Zeitmessvorrichtung auf die gemeinsame Zeitbasis einzustellen. Diese Slave-Vorrichtung 12 stellt an ihrem Ausgang 32 das modulierte Referenztaktsignal für weitere Slave-Vorrichtungen 12 bereit.

## Patentansprüche

1. Zeitlich synchronisiertes Messsystem, umfassend:
- mindestens eine Master-Vorrichtung (10);
- mindestens eine Slave-Vorrichtung (12),
wobei die Master- (10) und die Slave-Vorrichtung (12) jeweils eine Zeitmessvorrichtung (26; 30) umfassen und ausgelegt sind, den jeweiligen Zeitpunkt des Sendens und/oder des Empfangs einer Messinformation der jeweiligen Messinformation zuzuordnen,
wobei die Master-Vorrichtung (10) eine Referenztakterzeugungsvorrichtung (24) umfasst und ausgelegt ist, ein von der Referenztakterzeugungsvorrichtung (24) erzeugtes Referenztaktsignal (Clk) an die Slave-Vorrichtung (12) zu übermitteln,
**dadurch gekennzeichnet,**
**dass** das Referenztaktsignal (Clk) moduliert ist, wobei die Modulation eine Information zu einer gemeinsamen Zeitbasis der Master- (10) und der Slave-Vorrichtung (12) umfasst.

2. System nach Anspruch 1,
**dadurch gekennzeichnet,**
**dass** die Master-Vorrichtung (10) eine Master-Kommunikationsvorrichtung, die Slave-Vorrichtung (12) eine Slave-Kommunikationsvorrichtung und die Messinformation eine Protokollnachricht in einem Telekommunikationsnetzwerk ist.

3. System nach einem der Ansprüche 1 oder 2,
**dadurch gekennzeichnet,**
**dass** die gemeinsame Zeitbasis die Absolutzeit ist.

4. System nach einem der Ansprüche 1 oder 2,
**dadurch gekennzeichnet,**
**dass** die gemeinsame Zeitbasis eine Systemzeit, insbesondere eine Testzeit, ist.

5. System nach einem der vorhergehenden Ansprüche,
**dadurch gekennzeichnet,**
**dass** das übertragene Referenztaktsignal (Clk) gleichstromfrei ist und die Modulation derart erfolgt, dass auch das modulierte Referenztaktsignal (Clk) gleichstromfrei übertragbar ist.

6. System nach einem der vorhergehenden Ansprüche,
**dadurch gekennzeichnet,**
**dass** die Modulation darin besteht, dass ein zwischen der Master- (10) und der Slave-Vorrichtung (12) vereinbartes Signal den Start einer Systemzeit definiert.

7. System nach einem der vorhergehenden Ansprüche,
**dadurch gekennzeichnet,**
**dass** die Modulation darin besteht, dass die aktuelle Zeit bezogen auf die gemeinsame Zeitbasis, insbesondere die Absolutzeit, mit Bezug auf ein zwischen der Master- (10) und der Slave-Vorrichtung (12) vereinbartes Signal in kodierter Form übertragen wird.

8. System nach einem der vorhergehenden Ansprüche,
**dadurch gekennzeichnet,**
**dass** die Master-Vorrichtung (10) eine Laufzeitermittlungsvorrichtung umfasst, die die Laufzeit des Referenztaktsignals (Clk) zwischen der Master- (10) und der Slave-Vorrichtung (12) ermittelt und diese Laufzeit bei der Modulation des Referenztaktsignals (Clk) berücksichtigt.

9. System nach einem der vorhergehenden Ansprüche,
**dadurch gekennzeichnet,**
**dass** mindestens eine erste (10) und eine zweite Master-Vorrichtung vorgesehen sind, wobei jede Master-Vorrichtung eine Referenztakterzeugungsvorrichtung (24) und eine Zeitmessvorrichtung (26) umfasst, die nicht miteinander synchronisiert sind, und einen GPS-Empfänger (34), wobei jeder GPS-Empfänger ausgelegt ist, ein Pulssignal, insbesondere mit einem Puls pro Sekunde, zu empfangen und an die jeweilige Referenztakterzeugungsvorrichtung (24) zum Zwecke der Synchronisation bereitzustellen, und ein Absolutzeitsignal zu empfangen und zur Einstellung der jeweiligen Zeitmessvorrichtung an die jeweilige Zeitmessvorrichtung bereitzustellen.

10. System nach einem der vorhergehenden Ansprüche,
**dadurch gekennzeichnet,**
**dass** das Referenztaktsignal (Clk) 10 MHz beträgt.

11. System nach einem der vorhergehenden Ansprüche,
**dadurch gekennzeichnet,**
**dass** im modulierten Referenztaktsignal (Clk) eine logische "0" definiert ist
durch eine Periode des Referenztaktsignals (Clk) mit einem 75/25 Tastverhältnis und eine Periode des Referenztaktsignals (Clk) mit einem 25/75 Tastverhältnis, und
eine logische "1" definiert ist
durch zwei Perioden des Referenztaktsignals (Clk) mit einem 75/25 Tastverhältnis und zwei Perioden des Referenztaktsignals (Clk) mit einem 25/75 Tastverhältnis und
durch zwei Perioden des Referenztaktsignals (Clk) mit einem 25/75 Tastverhältnis und zwei Perioden des Referenztaktsignals (Clk) mit einem 75/25 Tastverhältnis.

12. System nach einem der vorhergehenden Ansprüche,
**dadurch gekennzeichnet,**
**dass** mehrere Slave-Vorrichtungen (12) vorhanden sind, wobei jede Slave-Vorrichtung (12) einen Ausgang (32) aufweist, an dem sie das modulierte Referenztaktsignal Clk) an eine weitere Slave-Vorrichtung (12) bereitstellt.

13. Verfahren zum zeitlichen Synchronisieren von mindestens einer Master- (10) und einer Slave-Vorrichtung (12), wobei die Master- (10) und die Slave-Vorrichtung (12) jeweils eine Zeitmessvorrichtung (26; 30) umfassen und der jeweilige Zeitpunkt des Sendens und/oder des Empfangs einer Messinformation der jeweiligen Messinformation zugeordnet wird, wobei die Master-Vorrichtung (10) eine Referenztakterzeugungsvorrichtung (24) umfasst und ein von der Referenztakterzeugungsvorrichtung (24) erzeugtes Referenztaktsignal (Clk) an die Slave-Vorrichtung (12) übermittelt wird,
**dadurch gekennzeichnet,**
**dass** das Referenztaktsignal (Clk) moduliert wird, wobei die Modulation eine Information zu einer gemeinsamen Zeitbasis der Master- (10) und der Slave-Vorrichtung (12) umfasst.

## Claims

1. Time-synchronised measurement system, comprising:
- at least one master device (10);
- at least one slave device (12),
whereby the master device (10) and the slave device (12) each comprise a time measurement device (26; 30) and are designed to assign the relevant time of the sending and/or the receipt of a piece of measurement information to the corresponding piece of measurement information,
whereby the master device (10) comprises a reference clock pulse-generating device (24) and is designed to transfer to the slave device (12) a reference clock signal (Clk) generated by the reference clock pulse-generating device (24),
**characterised in that**
the reference clock signal (Clk) is modulated, whereby the modulation comprises a piece of information on a common time basis of the master device (10) and the slave device (12).

2. System according to claim 1,
**characterised in that**
the master device (10) is a master communication device, the slave device (12) is a slave communication device, and the measurement information is a protocol message in a telecommunication network.

3. System according to one of claims 1 or 2,
**characterised in that**
the common time basis is the absolute time.

4. System according to one of claims 1 or 2,
**characterised in that**
the common time basis is a system time, particularly a test time.

5. System according to one of the above claims,
**characterised in that**
the transmitted reference clock signal (Clk) is DC-free and that the modulation takes place such that the modulated reference clock signal (Clk), too, is transmittable DC-free.

6. System according to one of the above claims,
**characterised in that**
the modulation consists **in that** a signal agreed between the master device (10) and the slave device (12) defines the start of a system time.

7. System according to one of the above claims,
**characterised in that**
the modulation consists **in that** the current time related to the common time basis, particularly the absolute time, is transmitted with reference to a signal agreed between the master device (10) and the slave device (12) in an encoded form.

8. System according to one of the above claims,
**characterised in that**
the master device (10) comprises a propagation time determination device, which determines the propagation time of the reference clock signals (Clk) between the master device (10) and the slave device (12) and takes said propagation time into account for the modulation of reference clock signal (Clk).

9. System according to one of the above claims,
**characterised in that**
at least one first (10) and one second master device are envisaged, whereby every master device comprises a reference clock pulse-generating device (24) and a time measurement device (26), which are not synchronised with each other, and a GPS receiver (34), whereby each GPS receiver is designed to receive a pulse signal, particularly at one pulse per second, and make it available to the corresponding reference clock pulse-generating device (24) for the purpose of synchronisation, and to receive an absolute time signal and make it available to the corresponding time measurement device for setting the time measurement device.

10. System according to one of the above claims,
**characterised in that**
the reference clock signal (Clk) is 10 MHz.

11. System according to one of the above claims,
**characterised in that**
in the modulated reference clock signal (Clk) a logic "0" is defined
by one period of the reference clock signal (Clk) having a 75/25 duty cycle and one period of the reference clock signals (Clk) having a 25/75 duty cycle,
and
a logic "1" is defined
by two periods of the reference clock signal (Clk) having a 75/25 duty cycle and two periods of the reference cbck signal (Clk) having a 25/75 duty cycle
and
by two periods of reference clock signal (Clk) having a 25/75 duty cycle and two periods of reference clock signals (Clk) having a 75/25 duty cycle.

12. System according to one of the above claims,
**characterised in that**
there are several slave devices (12), whereby each slave device (12) exhibits an output (32), at which it makes the modulated reference clock signal (Clk) available to another slave device (12).

13. Method for the time synchronisation of at least one master device (10) and one slave device (12), whereby the master device (10) and the slave device (12) each comprise a time measurement device (26; 30) and the relevant time of the sending and/or the receipt of a piece of measurement information is assigned to the corresponding piece of measurement information, whereby the master device (10) comprises a reference clock pulse-generating device (24), and a reference clock signal (Clk) generated by the reference clock pulse-generating device (24) is transferred to the slave device (12),
**characterised in that**
the reference clock signal (Clk) is modulated, whereby the modulation comprises a piece of information on a common time basis of the master device (10) and the slave device (12).

## Revendications

1. Dispositif de mesure, synchronisé dans le temps, comprenant :
- au moins un dispositif maître (10) ;
- au moins un dispositif esclave (12) ;
les dispositifs maître (10) et esclave (12) comprenant respectivement un dispositif de mesure de temps (26 ; 30) et étant conçus pour affecter le moment respectif de l'émission et / ou de la réception d'une information de mesure de l'information respective de mesure,
le dispositif maître (10) comprenant un dispositif de production d'impulsions de référence (24) et étant conçu pour transmettre un signal d'impulsions de référence (Clk), produit par le dispositif de production d'impulsions de référence (24), au dispositif esclave (12),
**caractérisé en ce**
**que** le signal d'impulsion de référence (Clk) est modulé, la modulation comprenant une information, relative à une base de temps commune des dispositifs maître (10) et esclave (12).

2. Système suivant la revendication 1,
**caractérisé en ce**
**que** le dispositif maître (10) est un dispositif de communication maître, le dispositif esclave (12) est un dispositif de communication esclave et l'information de mesure est un message de journal dans un réseau de télécommunications.

3. Système suivant l'une des revendications 1 ou 2,
**caractérisé en ce**
**que** la base de temps commune est le temps absolu.

4. Système suivant l'une des revendications 1 ou 2,
**caractérisé en ce**
**que** la base de temps commune est un temps système, en particulier un temps de test.

5. Système suivant l'une des revendications précédentes,
**caractérisé en ce**
**que** le signal d'impulsion de référence (Clk) transféré est sans courant continu et que la modulation se produit de telle sorte le signal d'impulsion de référence (Clk) modulé peut aussi être transféré sans courant continu.

6. Système suivant l'une des revendications précédentes,
**caractérisé en ce**
**que** la modulation consiste en ce qu'un signal, convenu entre les dispositifs maître (10) et esclave (12), définit le début d'un temps système.

7. Système suivant l'une des revendications précédentes,
**caractérisé en ce**
**que** la modulation consiste en ce que le temps actuel, relatif à la base de temps commune, en particulier le temps absolu, est transféré sous forme codée par rapport à un signal, convenu entre les dispositifs maître (10) et esclave (12).

8. Système suivant l'une des revendications précédentes,
**caractérisé en ce**
**que** le dispositif maître (10) comprend un dispositif de détermination du temps de fonctionnement, qui détermine le temps de fonctionnement du signal d'impulsion de référence (Clk) entre les dispositifs maître (10) et esclave (12) et tient compte de ce temps de fonctionnement lors de la modulation du signal d'impulsion de référence (Clk).

9. Système suivant l'une des revendications précédentes,
**caractérisé en ce**
**qu'**au moins un premier (10) et un second dispositif maître sont prévus, chaque dispositif maître comprenant un dispositif de production d'impulsions de référence (24) et un dispositif de mesure de temps (26), qui ne sont pas synchronisés entre eux et un récepteur GPS (34), chaque récepteur GPS étant conçu pour recevoir un signal d'impulsion, en particulier avec une impulsion par seconde et pour le mettre à disposition du dispositif respectif de production d'impulsions de référence (24) en vue de la synchronisation et pour recevoir un signal de temps absolu et pour le mettre à disposition, en vue du réglage du dispositif respectif de mesure du temps, du dispositif respectif de mesure du temps.

10. Système suivant l'une des revendications précédentes,
**caractérisé en ce**
**que** le signal d'impulsion de référence (Clk) fait 10 MHz.

11. Système suivant l'une des revendications précédentes,
**caractérisé en ce**
**qu'**un " 0 " logique est défini dans le signal modulé d'impulsion de référence (Clk),
par le biais d'une période du signal d'impulsion de référence (Clk), avec un facteur d'utilisation des impulsions de 75/25 et d'une période du signal d'impulsion de référence (Clk), avec un facteur d'utilisation de 25/75 et
**qu'**un " 1 " logique est défini
par le biais de deux périodes du signal d'impulsion de référence (Clk), avec un facteur d'utilisation des impulsions de 75/25 et de deux périodes du signal d'impulsion de référence (Clk), avec un facteur d'utilisation de 25/75 et
par le biais de deux périodes du signal d'impulsion de référence (Clk), avec un facteur d'utilisation des impulsions de 25/75 et de deux périodes du signal d'impulsion de référence (Clk), avec un facteur d'utilisation de 75/25.

12. Système suivant l'une des revendications précédentes,
**caractérisé en ce**
**qu'**il existe plusieurs dispositifs esclaves (12), chaque dispositif esclave (12) présentant une sortie (32), à laquelle il met à disposition le signal d'impulsion de référence (Clk) modulé à un autre dispositif esclave (12).

13. Procédé en vue de la synchronisation dans le temps d'au moins un dispositif maître (10) et un dispositif esclave (12), les dispositifs maître (10) et esclave (12) comprenant respectivement un dispositif de mesure de temps (26 ; 30) et le moment respectif de l'émission et / ou de la réception d'une information de mesure étant affecté à l'information respective de mesure, le dispositif maître (10) comprenant un dispositif de production d'impulsions de référence (24) et un signal d'impulsion de référence (Clk), produit par le dispositif de production d'impulsions de référence (24), étant transmis au dispositif esclave (12),
**caractérisé en ce**
**que** le signal d'impulsion de référence (Clk) est modulé, la modulation comprenant une information sur une base de temps commune des dispositifs maître (10) et esclave (12).
